(19) **Europäisches Patentamt**

**European Patent Office**

**Office européen des brevets**

(11) **EP 0 953 611 B1**

(12) **EUROPEAN PATENT SPECIFICATION**

(45) Date of publication and mention
of the grant of the patent:
**18.01.2006 Bulletin 2006/03**

(51) Int Cl.:
*C09D 5/14* *(2006.01)*     *H05K 3/28* *(2006.01)*

(21) Application number: **98953036.5**

(22) Date of filing: **13.11.1998**

(86) International application number:
**PCT/JP1998/005114**

(87) International publication number:
**WO 1999/025777 (27.05.1999 Gazette 1999/21)**

(54) **REPELLENT-CONTAINING MATERIAL FOR ELECTRONIC COMPONENTS, ELECTRONIC COMPONENTS MADE BY USING THE SAME, AND PROCESS FOR THE PRODUCTION OF THE COMPONENTS**

SCHÄDLINGSABSTOSSENDES MITTEL FÜR ELEKTRONISCHE KOMPONENTE, ELEKTRONISCHE KOMPONENTE ERHALTEN UNTER VERWENDUNG DESSELBEN UND VERFAHREN ZUR DEREN HERSTELLUNG

MATIERE CONTENANT UN REPULSIF ET DESTINEE A DES COMPOSANTS ELECTRONIQUES, COMPOSANTS ELECTRONIQUES FABRIQUES A PARTIR DE CETTE MATIERE, ET PROCEDE DE PRODUCTION DE CES COMPOSANTS

(84) Designated Contracting States:
**DE FR IT**

(30) Priority: **18.11.1997 JP 31676597**

(43) Date of publication of application:
**03.11.1999 Bulletin 1999/44**

(73) Proprietor: **MATSUSHITA ELECTRIC INDUSTRIAL CO., LTD.**
**Kadoma-shi, Osaka 571-8501 (JP)**

(72) Inventors:
• **IWASAKI, Kazumi**
**Nara 631-0805 (JP)**

• **TOMIOKA, Toshikazu**
**Osaka 567-0851 (JP)**

(74) Representative: **Kügele, Bernhard et al**
**Novagraaf SA**
**25, Avenue du Pailly**
**1220 Les Avanchets - Geneva (CH)**

(56) References cited:
**EP-A- 0 733 658**     **JP-A- 2 020 094**
**JP-A- 2 274 774**     **JP-A- 7 118 112**

**Description**

TECHNICAL FIELD

The present invention relates to an electronic material and an electronic component, and more particular to an electronic material effective for pest control of electronic appliances of which reliability may be spoiled by insects, and an electronic component using the same.

BACKGROUND ART

Hitherto, effective measures have not be taken against invasion of cockroaches, ants and other insects into electronic appliances. Without installing pest control measures within the electronic appliances, invasion of insects into the electronic appliances was prevented by slight modifications of the casing shape of the electronic appliances, and pest control measures were not executed in the environments of using the electronic appliances. Accordingly, troubles of electronic appliances were often caused by the dead bodies and excrements of insects.

However, in the recent trend of diversification of electronic appliances and growth of restaurant industry, enhancement of reliability is strongly demanded in the electronic appliances used in the air conditioner, security system, electronic cooking apparatus, industrial telephone, professional kitchen and restaurant, and pest control measures of the electronic appliance itself are needed.

As the electronic material, electronic materials containing repellent by mixing resin and repellent directly are known (for example, Japanese Laid-open Patent No. 2-20094). In this conventional electronic material containing repellent, the repellent is directly mixed into the resin, and in its manufacturing process, therefore, the repellent is likely to be eluted, decomposed, polymerized, evaporated, or dissipated due to solvent, heat, ultraviolet rays, or the like, and even after manufacture, evaporation, dissipation and decomposition of the repellent are likely to occur, and sufficient pest control effect was not obtained and its duration was short.

In the conventional electronic material containing repellent, therefore, in order to express a sufficient pest control effect, it was necessary to mix a large content of repellent, which caused blurring, impaired printability, and causes to increase the cost. Further, film forming properties such as film surface hardness of the adhered electronic material containing repellent were impaired, and the appearance became poor, and quality problems were known. Thus, the conventional electronic materials containing repellent obtained by mixing the repellent directly into the resin involved various problems for industrial use.

It is an object of the invention to present an electronic material containing repellent capable of exhibiting the pest control effect effectively without using a large amount of repellent and keeping the effect for a long period, and an electronic material containing repellent of low cost, less likely to cause blurring, and having excellent printability and film forming properties.

SUMMARY OF THE INVENTION

An electronic material to be heated during a process of manufacturing an electronic component, according to the present invention, includes :

> a paint material;
> a filler mixed to said paint material;
> a pyrethroid insect repellent carried by said filler, characterized in that,

said paint material includes a resin component, said insect repellent has a heat resistant temperature of 200 °C or more, from 2 parts by weight to 200 parts by weight of said filler against 100 parts by weight of said resin component is included in said paint material, and said resin component forms an insect repellent layer by being cured by at least one of an ultraviolet ray irradiation and heating.

An electronic component to be performed soldering process according to the present invention comprises

> (a) an electronic element, and
> (b) an insect repellent layer being disposed on a surface of said electronic element,
> characterized in that,
> said insect repellent layer is formed by one of an ultraviolet ray irradiation and heating of the electronic material of the present invention.

A method of manufacturing an electronic component according to the present invention includes the steps of:

(a) forming an electronic material layer of claim 1 on a surface of an electronic element, and

(b) forming an insect repellent layer, by curing said electronic material layer formed on the surface of said electronic element by at least one of an ultraviolet ray irradiation and heating.

In this constitution, since the repellent is carried in the filler, the loss of the repellent due to evaporation or dissipation in the manufacturing process of electronic material decreases, and the loss speed of the repellent contained in the repellent layer formed on the surface of the electronic element due to evaporation or dissipation is lowered, and therefore the consumption of the repellent is saved substantially, and the repellent effect is maintained for a long period.

Moreover, since the content of the repellent can be decreased, and it is possible to obtain an electronic material containing repellent of low cost, less likely to cause blurring, and having excellent printability and film forming properties.

Still more, by applying this material containing repellent in a part or parts of the electronic element, the same effect as when applied in the entire electronic element is obtained, so that the electronic component further decreased in consumption and cost of the repellent is obtained.

BRIEF DESCRIPTION OF THE DRAWINGS

Fig. 1 is a sectional view of essential parts of an electronic component using an electronic material in an embodiment of the invention.

Fig. 2 is a sectional view of essential parts of an electronic component using an electronic material in an embodiment of the invention.

Fig. 3 is a sectional view of essential parts of other electronic component using an electronic material in an embodiment of the invention.

Fig. 4 is a process drawing showing a manufacturing method of an electronic component using an electronic material in an embodiment of the invention.

BEST MODE OF CARRYING OUT THE INVENTION

The electronic material to be heated during a process of manufacturing an electronic component, according to the present invention includes:

a paint material;

a filler mixed to said paint material;

a pyrethroid insect repellent carried by said filler,

characterized in that said paint material includes a resin component, said insect repellent has a heat resistant temperature of 200 °C or more, from 2 parts by weight to 200 parts by weight of said filler against 100 parts by weight of said resin component is included in said paint material, and said resin component forms an insect repellent layer by being cured by at least one of an ultraviolet ray irradiation and heating.

Preferably, the filler includes at least one selected from a group consisting of silica-gel, silica, barium sulfate, magnesium sulfate, titanium oxide, magnesium oxide, calcium oxide, bismuth oxide, vanadium oxide, talc, alumina, zeolite and diatomite.

Preferably, the paint material includes a plurality of fillers and at least one of said plurality of fillers carries said insect repellent.

The electronic component to be performed soldering process according to the present invention comprises :

(a) an electronic element, and

(b) an insect repellent layer being disposed on a surface of said electronic element,

characterized in that said insect repellent layer is formed by one of an ultraviolet ray irradiation and heating of the electronic material of the present invention.

Preferably, the insect repellent layer includes a plurality of fillers, at least one of said plurality of fillers carries said insect repellent and said filler carrying said insect repellent is dispersed in other fillers not carrying said insect repellent.

Preferably, the electronic element is a wiring board comprising an electric insulating substrate and conductive layers formed on said substrate, and said insect repellent layer is formed on a surface of said wiring board.

The method of manufacturing an electronic component according to the present invention includes the steps of:

(a) forming an electronic material layer of the present invention on a surface of an electronic element, and

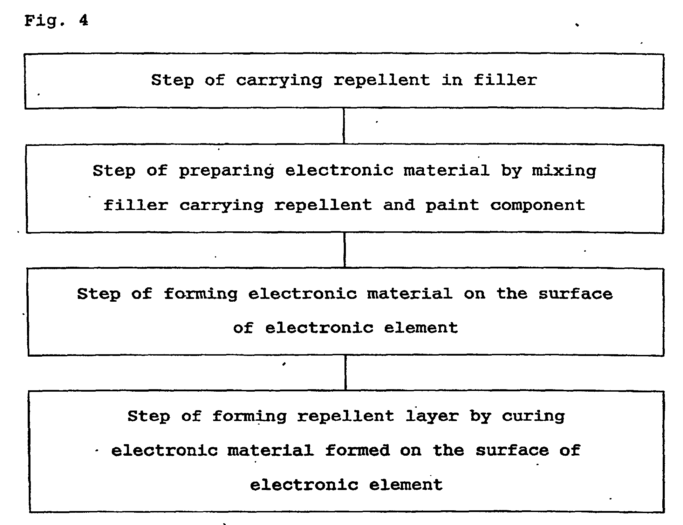

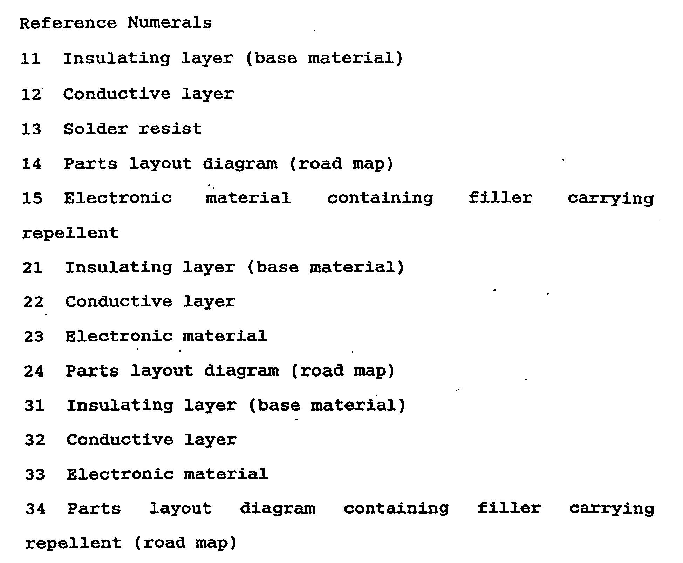

(b) forming an insect repellent layer, by curing said electronic material layer formed on the surface of said electronic element by at least one of an ultraviolet ray irradiation and heating. An outline of the manufacturing method is shown in Fig. 4.

Preferably, the electronic element is a wiring board comprising an electric insulating substrate and conductive layers formed on said substrate, and said insect repellent layer is formed on a surface of said wiring board.

Preferably, the electronic element comprises an electric insulating substrate, conductive layers formed on said substrate, and solder resist layer formed on said conductive layers, and said insect repellent layer is formed to cover said conductive layers in said step (a) .

Preferably, the insect repellent layer includes a plurality of fillers, at least one of said plurality of fillers carries said insect repellent and said filler carrying said insect repellent is dispersed in other fillers not carrying said insect repellent.

In the invention, the resin component contained in the paint component is preferred to be thermosetting resin, photosetting resin, or thermoplastic resin. Examples of thermosetting resin include epoxy resin, phenol resin, and epoxy denatured phenol resin. A hardener playing the role of crosslinking the resin by reacting chemically with the resin may be added to the paint component, and the usable hardeners include imidazole, dicyan diamide, diamino diphenyl methane, polyamide amine, diamino phenyl methane, polyamide amine, and aromatic polyamide amine. As a reaction promoter which may be added to the paint component, 4-dimethylamino-iso-amylbenzoate, 4-dimethylamino-ethyl benzoate, and others may be used. A solvent playing the role of providing an electronic material with viscosity, and controlling its viscosity may be added to the paint component, and examples of solvent include ethyl carbinol, butyl carbinol, and butyl cellosolve.

As the photosetting resin to be cured by light, for example, epoxy acrylate resin and urethane acrylate resin may be used. A reactive diluent having a function of forming a film by reacting with such resin and controlling the viscosity of the paint may be added to the paint component. Usable examples of reactive diluent include carbinol acrylate, trimethylol propane triacrylate, tetrahydrofurfuryl acrylate, and ethylene glycol diacrylate. A photoinitiator catalyst playing a role of generating active radicals or ions by irradiation with ultraviolet rays or other light, and polymerizing the photosetting resin or reactive diluent, or crosslinking and curing may be added to the pain component. Examples of photoinitiator catalyst include benzoine, benzyl, benzyl dimethyl ketal, thioxanthone, and benzoylether.

A peroxide catalyst having a function of generating active radicals by the heat by infrared rays contained in light or heat by heating, and polymerizing or crosslinking and curing such resin may be added to the paint component.

Examples of peroxide catalyst include t-butyl hydroperoxide, di-t-butyl peroxide, and capryl peroxide.

As the thermoplastic resin, ordinary plastic materials such as phenoxy resin are used, and in particular plastic materials having a high heat resisting temperature are preferred. The thermoplastic resin is dissolved in the resin, and becomes a paint component. This paint is applied on an electronic element such as wiring board, and the solvent is later evaporated and removed by heating, and a dried film is formed.

A coloring pigment is used for obtaining a colored repellent film, and usable examples of coloring pigment include cyanine blue, carbon black, chromium oxide, titanium yellow, calcium carbonate, barium sulfate and silica, among others.

The filler carrying the repellent is uniformly dispersed in the paint component, and therefore the electronic component of the Invention is smaller in the content of the repellent necessary for exhibiting an excellent repellent effect as compared with the conventional material having the repellent simply mixed in the paint component. Moreover, since the repellent is carried in the filler, the loss amount by evaporation is smaller during curing of the electronic material or heating when mounting other parts, and the loss of the repellent in the manufacturing process can be avoided.

As the repellent, a pyrethroid insect repellent having a head resistant temperature of 200°C or more which is a sensory nerve stimulant for stimulating the sensory nerves is used. Said sensory nerve stimulant is smaller in loss of the chemical by evaporation as compared with the chemical stimulating the olfaction, and hence maintains the repellent effect for a longer period.

The content of the filler having the repellent is from 2 parts by weight to 200 parts by weight in 100 parts by weight of the resin component, and preferably about 60 parts by weight to about 150 parts by weight. If the content of the filler is less than about 2 parts by weight, the hardness of the formed repellent layer is stiff, while the elasticity is lowered to become fragile, and it is likely to be broken. Besides, by heating of soldering or the like, distortion may occur between the repellent layer and its forming side due to excessive hardness, and the adhesion is lowered, and the formed repellent layer is likely to be peeled off. On the other hand, if the content of the filler exceeds about 200 parts by weight, the hardness of the formed repellent layer drops, and the physical strength is lowered. As a result, heat resistance, moisture resistance, and other environmental resistant characteristics are lowered.

Next, a constitution of forming a repellent layer on the surface of wiring board such as printed wiring board is described below. Semiconductors and other parts are mounted on the printed wiring board, and they are slightly heated as power is supplied. The growth speed of insects, for example, cockroaches is determined by the ambient temperature, and they are attracted to the atmosphere of 27 ±5 deg. C. On the printed wiring board, the surface temperature of the parts such as semiconductors is within this temperature range, and they are likely to nest on the surface, lower side or neighboring area. On the other hand, cockroaches search by antennae or fore-legs when invading onto the printed wiring board, and when the surface of the printed wiring board contacting with at this time has a repellent layer, further invasion is prevented and insects are repelled.

Generally, the surfaces of antennae and legs of insects having sensory nerves such as cockroaches and ants are composed of cuticular structure, which is different from the dermal structure of man. By making use of the difference between cockroach and man, an insect repellent effect is obtained by giving stimulation by a sensory nerve stimulant through the skin only to the insects having sensory nerves such as cockroaches and ants. By using the sensory nerve stimulant, unlike the olfactory stimulant, it is not necessary to heighten the vapor pressure of the chemical. Accordingly, waste of the chemical by evaporation and dissipation is suppressed, and a long-lasting performance is obtained. Further, by the learning effect of insects having sensory nerves such as cockroaches and ants, it is expected to prevent nesting by repeating this repellent effect several times.

Since the repellent is adsorbed on the filler, the repellent is hardly evaporated or dissipated or eluted in the solvent even in the severe conditions of manufacturing of printed wiring board or processing for mounting, and the loss is small, and it can withstand high temperature of soldering or reflow, so that the repellent existing in the repellent film is stable even in the manufacturing process exposed to high temperature.

The electronic element may be manufactured as an electronic component applying and forming a filler containing paste adsorbing the repellent on an integrated circuit element such as IC and LSI (with the mounting side of electronic component down), or an electronic component applying an electronic material containing a repellent adsorbing filler and a coloring pigment, with the repellent layer formed as relief characters or patterns of manufacturer's name, product number or the like (characters or patterns formed by blanking the top of the electronic component to expose the base color without printing).

Moreover, by applying a filler containing paint adsorbing a repellent on the printed wiring board, or electronic element such as IC or LSI selectively in a part or in parts, the nearly same repellent effect as when applied on the entire electronic element can be obtained efficiently, and the electronic component capable of saving the consumption of the repellent and lowering the cost is obtained.

Thus, the electronic component of the invention is capable of preventing deterioration of reliability due to invasion of insects having sensory nerves such as cockroaches and ants into an electronic appliance, and hence enhancing the reliability of the electronic appliance.

Exemplary embodiments of the invention are described below.

Embodiment 1

A filler containing a repellent was prepared by carrying a pyrethroid repellent as an insect repellent in silica gel.powder as filler. The pyrethroid repellent is a nerve transmitting chemical. Mixing this filler containing the repellent, together with hardener, reaction promoter, and solvent, an electronic material in a paste form was prepared. In 100 parts by weight of epoxy resin, the silica gel powder is contained in a range of 2 parts by weight to 200 parts by weight. In 100 parts by weight of epoxy resin, the content of the repellent is preferably in a range of about 1 part by weight to about 100 parts by weight. This paste electronic material was applied on the surface of a wiring board as an electronic element, and the applied electronic material was heated, and a cured repellent layer was formed. In the heating process, the solvent contained in the electronic material is evaporated, and the epoxy resin and hardener are cured by crosslinking chemical reaction. In the repellent layer formed by curing of the electronic material, the silica gel containing the repellent is dispersed and present in the cured resin component and on the surface. The solvent controls the viscosity of the paste of the electronic material.

As the repellent is carried in the silica gel, the repellent is firmly adsorbed in the pores of the silica gel and in convex and concave parts on the surface. Therefore, in the paste preparation process, the repellent is not separated from the filler, or lost or extremely decreased. When the electronic material applied on the electronic element is cured, since the solvent is removed by heating, the silica gel powder containing the repellent is closer to the surface of the formed repellent layer, or it is likely to be exposed, so that the insect repelling effect is enhanced. Moreover, the film of the repellent layer formed by using this electronic material -has excellent characteristics as the film such as excellent adhesion, electric insulation and smooth surface form. Still more, the repellent effect of the formed repellent layer is notably enhanced. Further since the repellent is firmly carried in the silica gel, the loss of repellent in a long term of use is decreased, so that the life of the repellent effect is notably extended. In addition, since the loss of the repellent in the manufacturing process and repellent layer is small, the required amount of the repellent is decreased, and the cost is lowered. The film hardness of the formed repellent layer is increased. Since both the repellent and the repellent layer have a high heat resistance, loss of repellent or deterioration of repellent layer does not occur due to high temperature caused by installation of other conductive layer or insulating layer. When mounting other electronic component, loss of repellent or deterioration of repellent layer does not occur due to thermal load of mounting. In an electronic appliance having such wiring board, if an insect having sensory nerves attempts to invade into the electronic appliance by thermal attraction or diet attraction, the sensory nerves of the insect (antennae, legs) contact with the film of the repellent layer placed on the wiring board, and invasion of the insect into the electronic appliance can be prevented by the action of the repellent at this time. Further, when this electronic material is used as solder resist, the same adhesion and reliability as the conventional ordinary solder resist can be obtained.

Incidentally, if the content of the repellent in 100 parts by weight of the epoxy resin is less than about 1 part by weight, the insect repelling effect is smaller, and if the content of the repellent exceeds about 100 parts by weight, the performance of the film of the repellent layer tends to be inferior. If the content of the filler containing the repellent in 100 parts by weight of the epoxy resin is less than about 2 parts by weight, the insect repelling effect is smaller, and if the content of the filler exceeds about 200 parts by weight, the performance of the film of the repellent layer tends to be inferior.

Embodiment 2

A filler containing a repellent was prepared by carrying a pyrethroid repellent as an insect repellent in silica gel powder as filler. Mixing this filler containing the repellent, together with epoxy acrylate resin, reactive diluent, and photoinitiator catalyst, an electronic material in a paste form was prepared. In 100 parts by weight of epoxy acrylate, the silica gel powder is contained in a range of 2 parts by weight to 200 parts by weight. In 100 parts by weight of epoxy acrylate resin, the content of the repellent is preferably in a range of about 1 part by weight to about 100 parts by weight. This paste electronic material was applied on the surface of a wiring board as an electronic element, and the applied electronic material was irradiated with light such as ultraviolet rays, and a cured repellent layer was formed. In this curing process, the epoxy acrylate and reactive diluent are cured by crosslinking chemical reaction by the action of the photoinitiator catalyst. In the repellent layer formed by curing of the electronic material, the silica gel containing the repellent is dispersed and present in the cured resin component and on the surface. The reactive diluent controls the viscosity of the paste of the electronic material.

Thus obtained electronic material and electronic component have the same effects as in embodiment 1. This repellent layer is particularly characterized by the ease of curing work.

Embodiment 3

A filler containing a repellent was prepared by carrying a pyrethroid repellent as an insect repellent in silica gel powder as filler. Mixing this filler containing the repellent, together with epoxy resin, hardener, reaction promoter, solvent, reactive diluent, pigment for coloring, and photoinitiator catalyst, an electronic material in a paste form was prepared. This paste electronic material was applied on the surface of a wiring board as an electronic element, and the applied electronic material was irradiated with light such as ultraviolet rays, and was further heated, then a cured repellent layer was formed. That is, this is a dual curing type of photosetting and thermosetting. In this curing process, the epoxy resin and hardener are cured by the action of the reaction promoter, and at the same time, the reactive diluent is cured by crosslinking chemical reaction by the action of the photoinitiator catalyst. In the repellent layer formed by curing of the electronic material, the silica gel containing the repellent is dispersed and present in the cured resin component and on the surface. The reactive diluent controls the viscosity of the paste of the electronic material. As the pigment, any desired pigment may be used, such as phthalocyanine compound, titanium oxide, or carbon black.

Thus obtained electronic material and electronic component have the same effects as in embodiment 1. This repellent layer is particularly characterized by excellent adhesion, excellent curing work efficiency, and control performance of paste viscosity.

Embodiment 4

A filler containing a repellent was prepared by carrying a pyrethroid repellent as an insect repellent in silica gel powder as filler. Mixing this filler containing the repellent, together with epoxy acrylate resin, reactive diluent, peroxide catalyst, and photoinitiator catalyst, an electronic material in a paste form was prepared. This paste electronic material was applied on the surface of a wiring board as an electronic element, and the applied electronic material was irradiated with light such as ultraviolet rays, and a cured repellent layer was formed. In this curing process, the epoxy acrylate resin and reactive diluent are cured by the action of the photoinitiator catalyst, and at the same time the peroxide catalyst promotes curing of the paste. In the repellent layer formed by curing of the electronic material, the silica gel containing the repellent is dispersed and present in the cured resin component and on the surface. The reactive diluent controls the viscosity of the paste of the electronic material.

Thus obtained electronic material and electronic component have the same effects as in embodiment 1. This repellent layer is particularly characterized by excellent adhesion and eases of curing work.

Embodiment 5

A filler containing a repellent was prepared by carrying a pyrethroid repellent as an insect repellent in silica gel powder as filler. Mixing this filler containing the repellent, together with phenol resin and solvent, an electronic material in a paste form was prepared. This paste electronic material was applied on the surface of a wiring board as an electronic element, and the applied electronic material was heated, and a cured repellent layer was formed. In this curing process, the phenol resin is cured by the action of heating, and at the same time the solvent is evaporated. In the repellent layer formed by curing of the electronic material, the silica gel containing the repellent is dispersed and present in the cured resin component and on the surface. The solvent controls the viscosity of the paste of the electronic material.
Thus obtained electronic material and electronic component have the same effects as in embodiment 1. This repellent layer has a particularly high heat resistance.

Embodiment 6

A filler containing a repellent was prepared by carrying a pyrethroid repellent as an insect repellent in silica gel powder as filler. Mixing this filler containing the repellent, together with epoxy denatured phenol resin and solvent, an electronic material in a paste form was prepared. This paste electronic material was applied on the surface of a wiring board as an electronic element, and the applied electronic material was heated, and a cured repellent layer was formed. In this curing process, the epoxy denatured phenol resin is cured by the action of heating, and at the same time the solvent is evaporated. In the repellent layer formed by curing of the electronic material, the silica gel containing the repellent is dispersed and present in the cured resin component and on the surface. The solvent controls the viscosity of the paste of the electronic material.
Thus obtained electronic material and electronic component have the same effects as in embodiment 1. This repellent layer has a particularly excellent adhesion and a high heat resistance.

Embodiment 7

A filler containing a repellent was prepared by carrying a pyrethroid repellent as an insect repellent in silica gel powder as filler. Mixing this filler containing the repellent, together with epoxy acrylate resin, urethane acrylate resin, reactive diluent, photoinitiator catalyst, and solvent, an electronic material in a paste form was prepared. This paste electronic material was applied on the surface of a wiring board as an electronic element, and the applied electronic material was irradiated with light, and a cured repellent layer was formed. In this curing process, the epoxy acrylate resin and urethane acrylate resin cured by the action of the photoinitiator catalyst, and at the same time the solvent is evaporated. In the repellent layer formed by curing of the electronic material, the silica gel containing the repellent is dispersed and present in the cured resin component and on the surface. The solvent controls the viscosity of the paste of the electronic material.
Thus obtained electronic material and electronic component have the same effects as in embodiment 1. This repellent layer has particularly excellent adhesion and flexibility.

Embodiment 9

In the foregoing embodiments 1 to 7, further, by adding coloring pigments such as titanium oxide, phthalocyanine green, phthalocyanine blue, other phthalocyanine compounds, chromium oxide, titanium yellow, carbon black, and iron oxide, electronic materials were prepared. Using thus constituted electronic materials, electronic components were fabricated same as in the embodiments. Thus, repellent layers having desired colors can be obtained.
Thus obtained electronic materials and electronic components have the same effects as in embodiment 1 through embodiment. In particular, by placing thus colored electronic materials in wiring boards as electronic elements by employing a printing technology, characters, patterns or parts layout diagrams may be formed, as well as having a repellent effect. The electronic material also has an action as a printing ink.

Embodiment 10

By using the electronic materials obtained in the foregoing embodiments 1 to 7, a first solder resist having a repellent function was prepared. On the other hand, an ordinary second solder resist not having repellent function was prepared. Further, as an electronic element, a wiring board having a conductive layer was prepared. Covering the conductive layer formed on the wiring board, the ordinary second solder resist was placed, and this second solder resist was cured, and a second solder resist layer was formed. On the cured second solder resist layer, the first solder resist was placed, and the first solder resist was cured, and a repellent layer was prepared. Thus, an electronic component having the repellent layer was fabricated.

Thus obtained electronic, components have the same effects as in embodiment 1 through embodiment 7. Moreover, in the soldering process, the repellent layer has a function of protecting the conductive circuit from soldering.

Embodiment 11

By using the electronic materials obtained in the foregoing embodiments 1 to 7, a first solder resist having a repellent function was prepared. Covering the conductive layer formed on the wiring board, the first solder resist was placed, and this first solder resist was cured, and a repellent layer was prepared. Thus, an electronic component having the repellent layer was fabricated.

Thus obtained electronic components have the same effects as in embodiment 1 through embodiment 7. Moreover, in the soldering process, the repellent layer has a function of protecting the conductive circuit from soldering.

Embodiment 12

By using the electronic materials obtained in the foregoing embodiment 9, a printing ink having a repellent function was prepared. Covering the conductive layer formed on the wiring board, an ordinary second solder resist was placed, and this second solder resist was cured, and a second solder resist layer was formed. On this second solder resist layer, using the printing ink, characters, patterns, or parts-layout diagrams were printed, and cured, and repellent layers were formed. Thus, electronic components having repellent layers were fabricated.

Thus obtained electronic components have the same effects as in embodiment 9. Moreover, the repellent layer has an information display function of characters, patterns, and parts layout diagrams.

Embodiment 13

As an electronic element, a wiring board having a mounting land and a conductive layer was prepared. The mounting land is a conductive layer for soldering. Further, using the electronic materials obtained in the foregoing embodiments 1 to 7 and 9, a paste was prepared. On the other hand, an ordinary second solder resist not having repellent function was prepared. Covering the conductive layer in the region excluding the mounting land with the ordinary second solder resist, it was cured and a second solder resist layer was formed. The paste was placed on the surface of this second solder resist layer, it was cured and a repellent layer was formed.

Thus obtained electronic components have the same effects as in embodiment 1 through embodiment 7 and embodiment 9. Moreover, when soldering other components on the soldering land, and excellent effect is obtained.

Embodiment 14

By using the electronic materials obtained in the foregoing embodiments 1 to 7 and 9, a paste having a repellent function was prepared. On the other hand, an ordinary second solder resist not having a repellent function was prepared. Covering the conductive layer in the region except for the mounting land, the ordinary second solder resist was placed, and this second solder resist was cured, and a second solder resist layer was formed. On the cured second solder resist layer, using the paste, a drawing layout of relief character type was placed, and an outer repellent margin of about 5 mm, in width was placed in the outer region of a wiring board. Curing the paste, a repellent layer having the drawing layout and outer repellent margin was prepared. Thus, an electronic component having the repellent layer was fabricated.

Thus obtained electronic components have the same effects as in embodiment 1 through embodiment 7 and embodiment 9. Moreover, invasion of insects into the wiring board is prevented by the outer repellent margin placed on the outer circumference of the wiring board.

Embodiment 15

By using the electronic materials obtained in the foregoing embodiments 1 to 7 and 9, a first solder resist having a repellent function was prepared. As an electronic element, a wiring board having a mounting land and a conductive layer was prepared. Covering the conductive layer in the region except for the mounting land, the first solder resist was placed, and this first solder resist was cured, and a repellent layer was formed. Thus, an electronic component having the repellent layer was prepared.

Thus obtained electronic components have the same effects as in embodiment 1 through embodiment 7 and embodiment 9. Moreover, in the soldering process, the repellent layer has a function of protecting the conductive circuit from soldering.

Embodiment 16

As an electronic element, a wiring board having a mounting land and a conductive layer was prepared. The mounting land is a conductive layer for soldering. By using the electronic materials obtained in the foregoing embodiments 1 to 7 and 9, a paste was prepared. On the other hand, an ordinary second solder resist not having a repellent function was prepared. The conductive layer in the region except for the mounting land was covered with the ordinary second solder resist, and it was cured, and a second solder resist layer was formed. The paste was placed on the surface of the second solder resist layer, and it was cured, and a repellent layer was formed. On the surface of the repellent layer, using an ordinary printing ink, a parts layout diagram was formed. The covering area of this parts layout diagram is about less than 80% of the area of the repellent layer. That is, more than about 20% of the area of the repellent layer is exposed to the surface.

Thus obtained electronic components have the same effects as in embodiment 1 through embodiment 7 and embodiment 9. In particular, if an insect having sensory nerves attempts to invade into the electronic appliance by thermal attraction or diet attraction, the sensory nerves of the insect (antennae, legs) contact with the film of the repellent layer placed on the wiring board, and invasion of the insect into the electronic appliance can be prevented by the repellent layer exposed on the wiring board.

**Embodiment 17**

By using the electronic materials obtained in the foregoing embodiments 1 to 7 and 9, a first solder resist having a repellent function was prepared. As an electronic element, a wiring board having a mounting land and a conductive layer was prepared. Covering the conductive layer in the region except for the mounting land, the first solder resist was placed, and this first solder resist was cured, and a repellent layer was formed. On the surface of the repellent layer, using an ordinary printing ink, a parts layout diagram was formed. The covering area of this parts layout diagram is about less than 80% of the area of the repellent layer. That is, more than about 20% of the area of the repellent layer is exposed to the surface.

Thus obtained electronic components have the same effects as in embodiment 1 through embodiment 7 and embodiment 9, and embodiment 19.

Embodiment 18

By using the electronic materials obtained in the foregoing embodiments 1 to 7 and 9, a paste having a repellent function was prepared. An ordinary second solder resist not having repellent function was also prepared. As an electronic element, a wiring board having a mounting land and a conductive layer was prepared. Covering the conductive layer in the region except for the mounting land, the second solder resist was placed, and this second solder resist was cured, and a second solder resist layer was formed. On the second solder resist layer, using a printing ink, a parts layout diagram was placed. The paste was placed on the surface of at least one of the formed second solder resist layer and pats layout diagram, and this paste was cured, and a repellent layer was formed. Thus, the wiring board having the repellent layer was fabricated.

Thus obtained electronic components have the same effects as in embodiment 1 through embodiment 7 and embodiment 9.

Embodiment 19

As an electronic element, a semiconductor integrated circuit element (IC or LSI) having terminals was prepared. The distance between terminals is as short as not to admit invasion of insects such as cockroach, larva of cockroach or ant. For example, the size of a larva of German cockroach is about 0.7 mm. Covering the region including the space between terminals, electronic materials obtained in the foregoing embodiments 1 to 7 and 9 were placed, and the electronic materials were cured, and repellent layers were formed. Thus, electronic components having repellent layers were fabricated.

Thus obtained electronic components have the same effects as in embodiment 1 through embodiment 7 and embodiment 9. In particular, in the electronic appliance using semiconductor integrated circuit elements, invasion of insects into the electronic appliance or nesting around the semiconductor integrated circuit can be prevented.

Embodiment 20

As an electronic element, a semiconductor integrated circuit element (IC or LSI) having terminals was prepared. The distance between terminals is as long as to admit invasion of insects such as cockroach, larva of cockroach or ant. For example, the size of a larva of German cockroach is about 0.7 mm. On both face side and back side of the region including the space between terminals, electronic materials obtained in the foregoing embodiments 1 to 7 and 9 were placed, and the electronic materials were cured, and repellent layers were formed. Thus, electronic components having repellent layers were fabricated.

Thus obtained electronic components have the same effects as in embodiment 1 through embodiment 7 and embodiment 9. In particular, in the electronic appliance using semiconductor integrated circuit elements, invasion of insects into the electronic appliance or nesting around the semiconductor integrated circuit can be prevented.

Embodiment 21

A capacitor, a cooling plate, and a semiconductor element were manufactured as electronic elements. The electronic materials obtained in the foregoing embodiments 1 to 7 and 9 were placed on the surface of the electronic elements, and cured, and repellent layers were formed. Thus, electronic components having repellent layers wore fabricated.

Thus obtained electronic components have the same effects as in embodiment 1 through embodiment 7 and embodiment 9.

Embodiment 22

A capacitor, a cooling plate, and a semiconductor element were manufactured as electronic elements. Using the electronic materials obtained in embodiment 9, printing inks were prepared. On the surface of these electronic elements, using these printing inks, characters, patterns, parts circuit diagrams or others were printed, and were cured, and repellent layers were formed. In this case, these patterns are preferred to be formed as relief characters. Thus, electronic components having repellent layers were fabricated.

Thus obtained electronic components have the same effects as in embodiment 9. Further, the repellent layer has an information display function of characters, patterns, or parts circuit diagrams.

Embodiment 23

Using at least one of silica, titanium oxide, barium sulfate, magnesium sulfate, talc, alumina, magnesium oxide, calcium oxide, bismuth oxide, zeolite, diatomaceous earth, and vanadium oxide, as silica, instead of silica gel used in embodiment 1 to embodiment 7 and embodiment 9, electronic materials having repellent function were prepared. Using these electronic materials, and placing them on the surface of electronic elements such as wiring board, semiconductor element, cooling plate, capacitor, or semiconductor integrated circuit, the electronic materials were cured, and repellent layers were formed. Thus, electronic components having repellent function were fabricated.

Thus obtained electronic materials and electronic components have the same effects as in embodiment 1 through embodiment 7 and embodiment 9.

Embodiment 24

In embodiment 1 through embodiment 7, embodiment 9, and embodiment 23, in addition to the filler carrying the repellent, at least one of ordinary silica, titanium oxide, barium sulfate, magnesium sulfate, talc, alumina, magnesium oxide, calcium oxide, bismuth oxide, zeolite, diatomaceous earth, and vanadium oxide was added, and electronic materials having repellent function were fabricated.

Using these electronic materials, and placing them on the surface of electronic elements such as wiring board, semiconductor element, cooling plate, capacitor, or semiconductor integrated circuit, the electronic materials were cured, and repellent layers were formed. In the formed repellent film, the filler carrying the repellent and the filler not having repellent are dispersed and present alternately. Thus, electronic components having repellent function were fabricated.

Thus obtained electronic materials and electronic components have the same effects as in embodiment 1 through embodiment 7 and embodiment 9.

Embodiment 25A

A specific example of an embodiment of the invention is described while referring to the accompanying drawings.

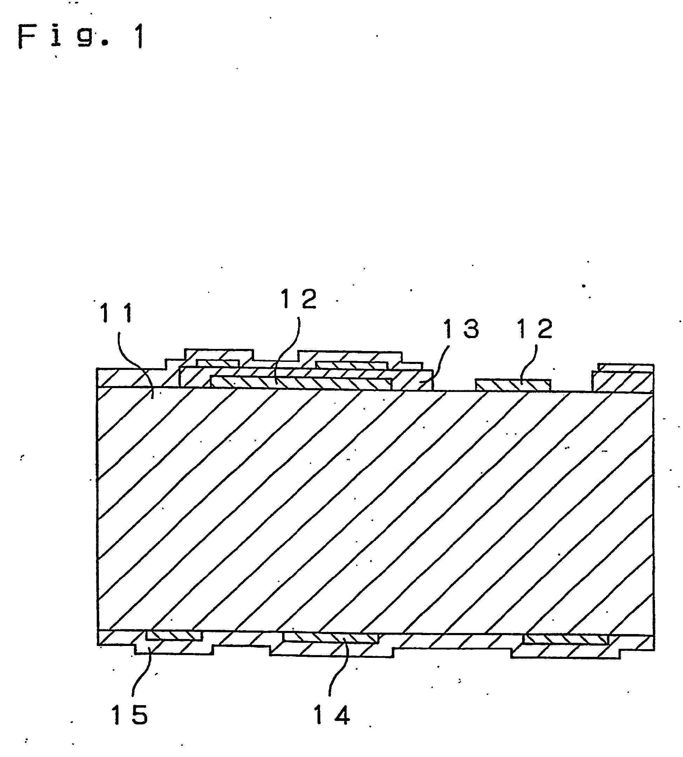

Fig. 1 shows an electronic component as an embodiment of the invention, which is a sectional view of essential parts of an electronic component using a printed wiring board having one side lined with copper as an electronic element. In Fig. 1, the electronic element has an insulating layer (base material) 11 of paper-phenol (FR-1), a copper foil of 35 microns in thickness as a conductive layer 12 formed on the surface of the insulating layer 11, and a parts layout diagram 14 formed on the back side. Covering the conductive layer 12, an ordinary ultraviolet-curing type solder resist 13 is formed. The parts layout diagram 14 is formed of an ultraviolet-curing type paste material. Covering the parts layout diagram 14, an electronic material 15 having a dual curing type repellent function of ultraviolet-curing type and thermosetting type is formed. The electronic material 15 comprises 100 parts by weight of epoxy acrylate resin, 45 parts by weight of methacrylic acid monomer as reactive diluent, 3 parts by weight of benzoine as photoinitiator catalyst, 2 parts by weight of peroxyl ester as peroxide catalyst, 120 parts by weight of silica gel adsorbing pyrethroid repellent, and 5 parts by weight of silica. The pyrethroid repellent is a sensory nerve stimulant having a heat resistant temperature of 200 deg. C or more. The electronic material placed on the electronic element was irradiated with ultraviolet ray, and a repellent layer was formed. Thus, an electronic component 25A was fabricated.

Embodiment 25B

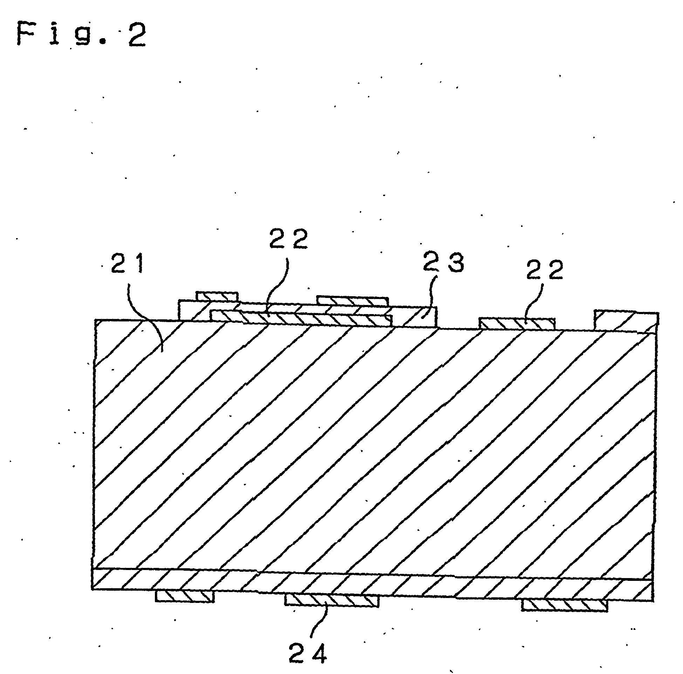

Fig. 2 shows an electronic component as other embodiment of the invention. In Fig. 2, a printed wiring board having one side lined with copper is used as an electronic element. The electronic element has an insulating layer (base material) 21 of paper-phenol (FR-1), a copper foil of 35 microns in thickness as a conductive layer 22 formed on the surface of the insulating layer 21, and a parts layout diagram 24 formed on the back side. Covering the conductive layer 22, an electronic material 23 containing a repellent is disposed. The electronic material 23 comprises 100 parts by weight of epoxy acrylate, 45 parts by weight of methacrylic acid monomer as reactive diluent, 3 parts by weight of benzoine as photoinitiator catalyst, 2 parts by weight of peroxyl ester as peroxide catalyst, 2 parts by weight of phthalocyanine green as coloring pigment, 130 parts by weight of silica gel containing repellent, and 5 parts by weight of silica powder. The repellent is a pyrethroid sensory nerve stimulant having a heat resistant temperature of 200 deg. C or more. Thus formed electronic material was irradiated with ultraviolet ray, and a cured repellent layer was formed. This formed repellent layer has a role as a solder resist. Thus, an electronic component 25B was fabricated.

Embodiment 25C

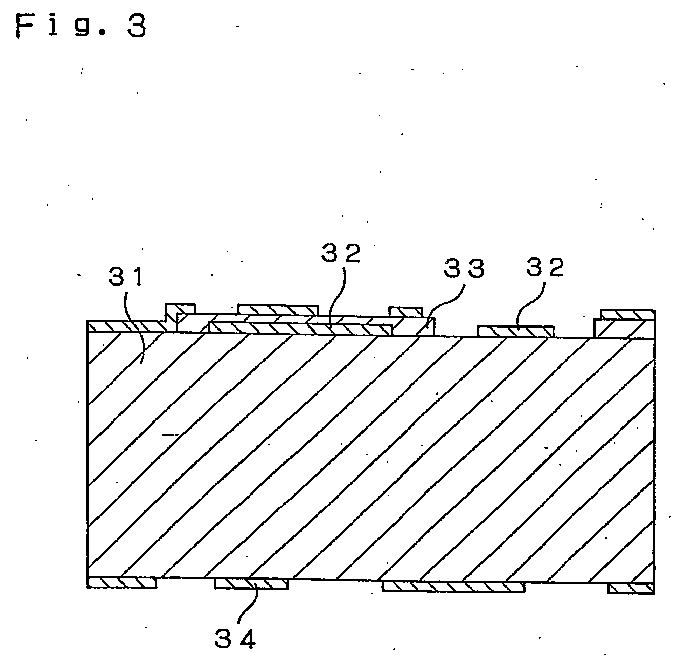

Fig. 3 shows an electronic component as a different embodiment of the invention. In Fig. 3, a printed wiring board having one side lined with copper is used as an electronic element. The electronic element has an insulating layer (base material) 31 of paper-phenol (FR-1), a copper foil of 35 microns in thickness as a conductive layer 32 formed on the surface of the insulating layer 31, and a parts layout diagram 34 formed on the back side. Covering the conductive layer 32, an electronic material 33 containing a repellent is formed. The electronic material 33 comprises 100 parts by weight of epoxy acrylate resin, 45 parts by weight of methacrylic acid monomer as reactive diluent, 3 parts by weight of benzoine as photoinitiator catalyst, 2 parts by weight of peroxyl ester as peroxide catalyst, 3 parts by weight of titanium oxide as coloring pigment, 110 parts by weight of silica gel containing repellent, and 5 parts by weight of talc powder. The repellent is a pyrethroid sensory nerve stimulant having a heat resistant temperature of 200 deg. C or more. Thus formed electronic material was irradiated with ultraviolet ray, and a cured repellent layer was formed. This formed repellent layer has a role as a solder resist. Thus, an electronic component 25C was fabricated.

In these three types of electronic components, the repellent performance of the electronic components was evaluated by using cockroaches as insects. The results are shown in Table 1. In the embodiments 25A, 25B, 25C, samples without placing repellent layer were also prepared as comparative examples. German cockroaches were put in a vinyl chloride vat of 80 X 100 cm, and a container containing a paper shelter (nest) and drinking water was put in the center, and electronic components having repellent layer and electronic component not having repellent layer were put at four corners of the vat, and the repellent performance was evaluated. In the study, 200 adult German cockroaches of each sex were used. The printed wiring board as electronic element was a specimen cut in a square of 10 cm each side. Cube sugar was put in the center of each electronic component, and the loss of weight of the cube sugar consumed by cockroaches was measured 48 hours later, and the repellent rate (see formula below) was calculated. As mentioned above, cockroaches tend to be attracted by heat, and it should be evaluated by thermal attraction method, as a rule, but in the embodiment, for quantitative evaluation, it was evaluated by diet attraction method.

The insect repellent rate was calculated in the following formula.

```
Insect repellent rate (%) = 100 X (cube sugar loss in
electronic component not having repellent layer - cube
sugar loss in electronic component having repellent layer)
/ cube sugar loss in uncoated component
```

Insect repellent rate (%) = 100 X (cube sugar loss in electronic component not having repellent layer - cube sugar loss in electronic component having repellent layer) / cube sugar loss in uncoated component

Table 1

| Sample No. | Cube sugar loss (mg) | | Insect repellent rate (%) |
|---|---|---|---|
| | Electronic component without repellent layer | Electronic component with repellent layer | |
| Sample 25A | 294.1<br>320.9<br>Average 307.5 | 40.2<br>55.4<br>Average 47.8 | 84.5 |
| Sample 25B | 261.4<br>303.8<br>Average 282.6 | 15.8<br>19.2<br>Average 17.5 | 93.8 |
| Sample 25C | 251.4<br>283.5<br>Average 267.5 | 31.6<br>28.3<br>Average 30.0 | 88.8 |

Table 1 discloses the following. In all samples of 25A, 25B, 25C, the loss of cube sugar in the electronic components forming repellent layer was extremely smaller than the loss of cube sugar in the electronic components without repellent layer. The insect repellent rate was in a range of about 84% to 94%. That is, the electronic components having the repellent layers of the embodiments have an excellent repellent effect.

INDUSTRIAL APPLICABILITY

In the constitution of the invention, sine the repellent is carried in the filler, the loss of the repellent due to evaporation or dissipation during manufacturing process of the electronic material is decreased, and the loss speed of the repellent contained in the repellent layer formed on the surface of the electronic component due to evaporation or dissipation slows down, so that the consumption of the repellent may be saved substantially, and the repellent effect can be maintained for a long period.

Moreover, since the content of the repellent may be decreased, it is possible to obtain an electronic material containing repellent low in cost, less likely to blur, and having excellent printability and film forming performance. Moreover, by applying this electronic material containing repellent in part or parts of the electronic element, nearly the same repellent effect as when applied on the entire electronic element is obtained efficiently, and the consumption of the repellent is further saved and the electronic component of lower cost will be obtained. As a result, invasion or staying of insects in electronic appliances can be prevented, and occurrence of troubles of electronic appliances due to dead bodies or excrements of insects can be prevented, and therefore the reliability of electronic appliances can be notably enhanced, and adverse effects on the human health can be reduced.

**Claims**

1.  An electronic material to be heated during a process of manufacturing an electronic component, said electronic material including:

a paint material;
a filler mixed to said paint material;
a pyrethroid insect repellent carried by said filler,

**characterized in that**,
said paint material includes a resin component, said insect repellent has a heat resistant temperature of 200°C or more, from 2 parts by weight to 200 parts by weight of said filler against 100 parts by weight of said resin component is included in said paint material, and said resin component forms an insect repellent layer by being cured by at least one of an ultraviolet ray irradiation and heating.

2. The electronic material of claim 1, wherein said filler includes at least one selected from a group consisting of silica-gel, silica, barium sulfate, magnesium sulfate, titanium oxide, magnesium oxide, calcium oxide, bismuth oxide, vanadium oxide, talc, alumina, zeolite and diatomite.

3. The electronic material of claim 1, wherein said paint material includes a plurality of fillers and at least one of said plurality of fillers carries said insect repellent.

4. An electronic component to be performed soldering process comprising:

   (a) an electronic element, and
   (b) an insect repellent layer being disposed on a surface of said electronic element,
   **characterized in that**,
   said insect repellent layer is formed by one of an ultraviolet ray irradiation and heating of the electronic material of claim 1.

5. The electronic component of claim 4, wherein said insect repellent layer includes a plurality of fillers, at least one of said plurality of fillers carries said insect repellent and said filler carrying said insect repellent is dispersed in other fillers not carrying said insect repellent.

6. The electronic component of claim 4, wherein said electronic element is a wiring board comprising an electric insulating substrate and conductive layers formed on said substrate, and said insect repellent layer is formed on a surface of said wiring board.

7. A method of manufacturing an electronic component including the steps of:

   (a) forming an electronic material layer of claim 1 on a surface of an electronic element, and
   (b) forming an insect repellent layer, by curing said electronic material layer formed on the surface of said electronic element by at least one of an ultraviolet ray irradiation and heating.

8. The method of manufacturing an electronic component of claim 7, wherein said electronic element is a wiring board comprising an electric insulating substrate and conductive layers formed on said substrate, and said insect repellent layer is formed on a surface of said wiring board.

9. The method of manufacturing an electronic component of claim 7, wherein said electronic element comprises an electric insulating substrate, conductive layers formed on said substrate, and solder resist layer formed on said conductive layers, and said insect repellent layer is formed to cover said conductive layers in said step (a).

10. The method of manufacturing an electronic component of claim 7, wherein said insect repellent layer includes a plurality of fillers, at least one of said plurality of fillers carries said insect repellent and said filler carrying said insect repellent is dispersed in other fillers not carrying said insect repellent.

**Patentansprüche**

1. Elektronisches Material, das im Verlauf der Herstellung einer elektronischen Komponente zu erhitzen ist, wobei das elektronische Material enthält:

   ein Anstrichmaterial;

ein dem Anstrichmaterial beigemengtes Füllmaterial;
ein auf das Füllmaterial aufgetragenes, Insekten abstossendes Pyrethroid,
**dadurch gekennzeichnet, dass**
das Anstrichmaterial eine Harzkomponente enthält, das Insekten abstossende Mittel eine Hitzebeständigkeit von 200 °C oder mehr besitzt, zwei bis 200 Gewichtsteile des Füllmaterials gegenüber 100 Gewichtsteilen der Harzkomponente im Anstrichmaterial enthalten sind und die Harzkomponente eine Insekten abstossende Schicht bildet, indem sie zumindest entweder mit ultravioletter Strahlung oder durch Erhitzen ausgehärtet wird.

2. Elektronisches Material nach Anspruch 1, **dadurch gekennzeichnet, dass** das Füllmaterial zumindest einen Stoff enthält, der aus der Gruppe ausgewählt ist, die aus Silicagel, Siliciumoxid, Bariumsulfat, Magnesiumsulfat, Titanoxid, Magnesiumoxid, Calciumoxid, Bismutoxid, Vanadiumoxid, Talk, Aluminiumoxid, Zeolith und Diatomit besteht.

3. Elektronisches Material nach Anspruch 1, **dadurch gekennzeichnet, dass** das Anstrichmaterial eine Mehrzahl von Füllstoffen enthält und auf zumindest einen aus der Mehrzahl von Füllstoffen das Insekten abstossende Mittel aufgetragen ist.

4. Elektronische Komponente, die zu löten ist, umfassend:

   a) ein elektronisches Element und
   b) eine Insekten abstossende Schicht, die auf einer Oberfläche des elektronischen Elements ausgelegt wird,
   **dadurch gekennzeichnet, dass**
   die Insekten abstossende Schicht entweder durch ultraviolette Bestrahlung oder durch Erhitzen des elektronischen Materials des Anspruchs 1 gebildet wird.

5. Elektronische Komponente nach Anspruch 4, **dadurch gekennzeichnet, dass** die Insekten abstossende Schicht eine Mehrzahl von Füllstoffen enthält, auf zumindest einen aus der Mehrzahl von Füllstoffen das Insekten abstossende Mittel aufgetragen ist und der das Insekten abstossende Mittel tragende Füllstoff in den anderen, kein Insekten abstossendes Mittel tragenden Füllstoffen dispergiert wird.

6. Elektronische Komponente nach Anspruch 4, **dadurch gekennzeichnet, dass** das elektronische Element eine Leiterplatte mit einem elektrisch isolierenden Substrat und auf dem Substrat ausgebildeten leitenden Schichten ist und die Insekten abstossende Schicht auf einer Oberfläche der Leiterplatte gebildet wird.

7. Verfahren der Herstellung einer elektronischen Komponente, die Schritte beinhaltend:

   a) Ausbildung einer Schicht des elektronischen Materials von Anspruch 1 auf einer Oberfläche eines elektronischen Elements und
   b) Ausbildung einer Insekten abstossenden Schicht durch Aushärten der auf der Oberfläche des elektronischen Elements gebildeten Schicht des elektronischen Materials zumindest entweder durch ultraviolette Strahlung oder durch Erhitzen.

8. Verfahren der Herstellung einer elektronischen Komponente nach Anspruch 7, **dadurch gekennzeichnet, dass** das elektronische Element eine Leiterplatte mit einem elektrisch isolierenden Substrat und auf dem Substrat ausgebildeten leitenden Schichten ist und die Insekten abstossende Schicht auf einer Oberfläche der Leiterplatte gebildet wird.

9. Verfahren der Herstellung einer elektronischen Komponente nach Anspruch 7, **dadurch gekennzeichnet, dass** das elektronische Element ein elektrisch isolierendes Substrat, auf dem Substrat ausgebildete leitende Schichten und eine auf den leitenden Schichten ausgebildete lötfeste Schicht umfasst und die Insekten abstossende Schicht im Schritt (a) gebildet wird, um die leitenden Schichten zu überdecken.

10. Verfahren der Herstellung einer elektronischen Komponente nach Anspruch 7, **dadurch gekennzeichnet, dass** die Insekten abstossende Schicht eine Mehrzahl von Füllstoffen enthält, auf zumindest einen aus der Mehrzahl von Füllstoffen das Insekten abstossende Mittel aufgetragen ist und der das Insekten abstossende Mittel tragende Füllstoff in den anderen, kein Insekten abstossendes Mittel tragenden Füllstoffen dispergiert wird.

**Revendications**

1. Matériau électronique devant être chauffé pendant un processus de fabrication d'un composant électronique, ledit matériau électronique comprenant :

   un matériau de peinture,
   une matière de charge mélangée audit matériau de peinture,
   un insectifuge à base de pyrèthre porté par ladite matière de charge,

   **caractérisé en ce que**
   ledit matériau de peinture comprend un composant de résine, ledit insectifuge a une température de résistance à la chaleur de 200°C ou plus, de deux parties en poids à 200 parties en poids de ladite matière de charge contre 100 parties en poids dudit composant de résine est compris dans ledit matériau de peinture, et ledit composant de résine forme une couche insectifuge en étant polymérisé par au moins l'un d'une illumination aux rayons ultraviolets et d'un chauffage.

2. Matériau électronique selon la revendication 1, dans lequel ladite matière de charge comprend au moins un élément sélectionné parmi le groupe constitué d'un gel de silice, de silice, de sulfate de baryum, de sulfate de magnésium, d'oxyde de titane, d'oxyde de magnésium, d'oxyde de calcium, d'oxyde de bismuth, d'oxyde de vanadium, de talc, de l'alumine, de la zéolite et de la diatomite.

3. Matériau électronique selon la revendication 1, dans lequel ledit matériau de peinture comprend une pluralité de matières de charge et au moins l'une de ladite pluralité de matières de charge porte ledit insectifuge.

4. Composant électronique devant être réalisé par un procédé de soudure comprenant :

   (a) un élément électronique, et
   (b) une couche insectifuge étant disposée sur une surface dudit élément électronique,
   **caractérisé en ce que**,
   ladite couche insectifuge est formée par l'un d'une illumination aux rayons ultraviolets et d'un chauffage du matériau électronique de la revendication 1.

5. Composant électronique selon la revendication 4, dans lequel ladite couche insectifuge comprend une pluralité de matières de charge, au moins l'une de ladite pluralité de matières de charge porte ledit insectifuge et ladite matière de charge portant ledit insectifuge est dispersée sur d'autres matières de charge ne portant pas ledit insectifuge.

6. Composant électronique selon la revendication 4, dans lequel ledit élément électronique est une carte de connexion comprenant un substrat électriquement isolant et des couches conductrices formées sur ledit substrat, et ladite couche insectifuge est formée sur la surface de ladite carte de connexion.

7. Procédé de fabrication d'un composant électronique comprenant les étapes consistant à :

   (a) former une couche de matériau électronique selon la revendication 1 sur une surface d'un élément électronique, et
   (b) former une couche insectifuge en faisant polymériser ladite couche de matériau électronique formée sur la surface dudit élément électronique par le biais d'au moins l'un d'une illumination aux rayons ultraviolets et d'un chauffage.

8. Procédé de fabrication d'un composant électronique selon la revendication 7, dans lequel ledit élément électronique est une carte de connexion comprenant un substrat électriquement isolant et des couches conductrices formées sur ledit substrat, et ladite couche insectifuge est formée sur une surface de ladite carte de connexion.

9. Procédé de fabrication d'un composant électronique selon la revendication 7, dans lequel ledit élément électronique comprend un substrat électriquement isolant, des couches conductrices formées sur ledit substrat, et une couche de résine photosensible de soudure sur lesdites couches conductrices, et ladite couche' insectifuge est formée pour recouvrir lesdites couches conductrices dans ladite étape (a).

10. Procédé de fabrication d'un composant électronique selon la revendication 7, dans ladite couche insectifuge comprend une pluralité de matières de charge, au moins l'une de ladite pluralité de matières de charge porte ledit insectifuge et ladite matière de charge portant ledit insectifuge est dispersée dans d'autres matières de charge ne portant pas ledit insectifuge.

Fig. 1

# Fig. 2

# Fig. 3

Fig. 4

| Step of carrying repellent in filler |
|---|

| Step of preparing electronic material by mixing filler carrying repellent and paint component |
|---|

| Step of forming electronic material on the surface of electronic element |
|---|

| Step of forming repellent layer by curing electronic material formed on the surface of electronic element |
|---|

Reference Numerals

11  Insulating layer (base material)

12  Conductive layer

13  Solder resist

14  Parts layout diagram (road map)

15  Electronic material containing filler carrying repellent

21  Insulating layer (base material)

22  Conductive layer

23  Electronic material

24  Parts layout diagram (road map)

31  Insulating layer (base material)

32  Conductive layer

33  Electronic material

34  Parts layout diagram containing filler carrying repellent (road map)